# EUROPÄISCHE PATENTANMELDUNG

(11) **EP 3 547 268 A1**
(43) Veröffentlichungstag der Anmeldung: **02.10.2019**
(21) Anmeldenummer: 18165111.8
(22) Anmeldetag: 29.03.2018
(51) Int. Cl.: G06T 19/00, G05B 19/418, G05B 17/02

(54) **AUGMENTED-REALITY-VORRICHTUNG**

(71) Anmelder: Sick AG, 79183 Waldkirch (DE)
(72) Erfinder: Haberstroh, Frank, 79183 Waldkirch (DE); Felix, Schwer, 79104 Freiburg (DE)

(57) **Zusammenfassung**

Um einem Anwender eine leichte Orientierung in einem Netzwerk von Verbindungen einer Industrieanlage zu ermöglichen, ist eine Augmented-Reality-Vorrichtung (1) vorgesehen, umfassend eine Verarbeitungseinheit (1a), die zum Verarbeiten von Daten vorgesehen ist, und eine Anzeigeeinheit (1b) mit einem Sichtbereich (1c), die vorgesehen ist, eine Steuerung (2, 2a), Steuerungskomponenten und erste Verbindungen zwischen den Steuerungskomponenten als eine erweiterte reale Abbildung anzuzeigen, wobei die Steuerung (2, 2a) Sensordaten von zumindest einem Sensor (4, 4a) empfängt und Aktorsignale an zumindest einen Aktor (3, 3a) einer Industrieanlage sendet, wobei die Verarbeitungseinheit (1a) aus den Daten ein Modell der Industrieanlage mit der Steuerung (2, 2a), dem Sensor (4, 4a), dem Aktor (3, 3a) und zweiten Verbindungen (5a - 5g) als Anlagenkomponenten verarbeitet, und Positionsdaten der Anlagenkomponenten und der Anzeigeeinheit (1b) in das Modell verarbeitet, und wobei die Anzeigeeinheit (1b) ausgelegt ist, die Industrieanlage mit den Anlagenkomponenten und ihren zweiten Verbindungen (5a - 5g) in Abhängigkeit von der Position und dem Sichtbereich (1c) der Anzeigeeinheit in dem Modell als die erweiterte reale Abbildung darzustellen.

## Beschreibung

Die Erfindung betrifft eine Augmented-Reality-Vorrichtung gemäß dem Oberbegriff des Anspruchs 1, wobei die Augmented-Reality-Vorrichtung im Folgenden auch als AR-Vorrichtung bezeichnet wird.

Die AR-Vorrichtung wird in unterschiedlichsten Anwendungsgebieten eingesetzt. In der heutigen Industrie wird die AR-Vorrichtung beispielsweise eingesetzt, um einem Anwender eine Abbildung der realen Umgebung zusammen mit einer erweiterten Realitätsabbildung darzustellen, so dass der Anwender auf einfachste Weise eine mögliche Abweichung zwischen der realen Abbildung und der erweiterten Realitätsabbildung erkennen kann. Hieraus kann ein Anwender, der die AR-Vorrichtung benutzt, unterschiedlichste Informationen entnehmen und entsprechenden Maßnahmen ergreifen.

Beispielsweise erfasst die AR-Vorrichtung eine komplexe reale Verschaltung einer Steuerung bzw. eines Steuerschrankes als reale Umgebung und überlappt die Abbildung der realen Verschaltung mit einer berechneten virtuellen Verschaltung der Steuerung bzw. des Steuerschrankes als erweiterte Realitätsabbildung. Hierbei sieht der Anwender Eingangs- und Ausgangseinheiten der Steuerung als Steuerungskomponenten, wobei die Verschaltung Verbindungen zwischen den Steuerungskomponenten darstellt.

Aus der Überlappung kann der Anwender eine fehlerhafte Verschaltung oder eine verbesserte Verschaltung als die Abweichung zwischen der realen und virtuellen Verschaltung ersehen, so dass der Anwender anhand der dargestellten Abweichung die fehlerhafte Verschaltung korrigieren oder die verbesserte Verschaltung verknüpfen kann.

Solch eine AR-Vorrichtung wie in DE 199 53 739 C2 beschrieben, ermöglicht somit dem Anwender eine statische reale Umgebung der Steuerung mit erweiterter Realität wahrzunehmen und die Verschaltung der Steuerung gegebenenfalls zu verändern.

In heutigen Industrieanlagen sind die Steuerungen mit weitflächig angeordneten Sensoren und Aktoren verbunden, wobei die Verbindungen zwischen den Steuerungen, den Sensoren und den Aktoren wie ein Netzwerk nicht ohne Weiteres sichtbar bzw. erkennbar sind.

Somit hat die AR-Vorrichtung des Standes der Technik den Nachteil, dass der Anwender zwar die Verschaltung der einzelnen Steuerung real und virtuell sehen kann, jedoch die Verbindungen bzw. das Netzwerk der Industrieanlage nicht erkennt. Hierdurch ist es beispielsweise für den Anwender nicht ersichtlich, welche Sensoren oder Aktoren beeinflusst werden könnten, wenn er Verbindungen an der Steuerung ändert, so dass Fehler eines Betriebs der Industrieanlage resultieren können.

Es ist eine Aufgabe der Erfindung, eine Augmented-Reality-Vorrichtung bzw. AR-Vorrichtung derart zu verbessern, dass sich ein Anwender der AR-Vorrichtung einfach in einem Netzwerk von Verbindungen einer Industrieanlage zurechtfinden kann.

Die Aufgabe wird erfindungsgemäß gelöst durch eine Augmented-Reality-Vorrichtung mit den Merkmalen des Anspruchs 1.

Hierbei umfasst die Augmented-Reality-Vorrichtung eine Verarbeitungseinheit, die zum Verarbeiten von Daten vorgesehen ist, und eine Anzeigeeinheit mit einem Sichtbereich, die vorgesehen ist, eine Steuerung, Steuerungskomponenten und erste Verbindungen zwischen den Steuerungskomponenten als eine erweiterte reale Abbildung anzuzeigen, wobei die Steuerung Sensordaten von zumindest einem Sensor empfängt und Aktorsignale an zumindest einen Aktor einer Industrieanlage sendet, wobei die Verarbeitungseinheit aus den Daten ein Modell der Industrieanlage mit der Steuerung, dem Sensor, dem Aktor und zweiten Verbindungen als Anlagenkomponenten verarbeitet, und Positionsdaten der Anlagenkomponenten und der Anzeigeeinheit in das Modell verarbeitet, wobei die Anzeigeeinheit ausgelegt ist, die Industrieanlage mit den Anlagenkomponenten und ihren zweiten Verbindungen in Abhängigkeit von der Position und dem Sichtbereich der Anzeigeeinheit in dem Modell als die erweiterte reale Abbildung darzustellen.

Dies hat den Vorteil, dass der Anwender sämtliche Anlagenkomponenten, insbesondere ihre Positionen, innerhalb der Industrieanlage und die zweiten Verbindungen zwischen den Anlagenkomponenten einfach visuell erkennt. In diesem Zusammenhang werden unter erste Verbindungen die innerhalb der Steuerung befindlichen Verbindungen verstanden, und unter zweite Verbindungen die außerhalb der Steuerung befindlichen Verbindungen verstanden. Ferner wird unter der erweiterten realen Abbildung der Industrieanlage verstanden, dass über einer realen Abbildung der Industrieanlage eine auf dem Modell basierende virtuelle Abbildung der Industrieanlage mit den zweiten Verbindungen eingeblendet ist.

Gemäß einem bevorzugten Ausführungsbeispiel umfassen die Daten CAD-Daten der Industrieanlage, wodurch das Modell der Industrieanlage technisch einfach erstellbar ist.

Ferner sind gemäß einem bevorzugten Ausführungsbeispiel die Positionsdaten der Anzeigeeinheit als GPS-Daten mittels Satelliten oder lokale Positionsdaten mittels lokalen Sensoren an die Verarbeitungseinheit übermittelbar. Hierdurch ergibt sich der Vorteil, dass eine exakte Lokalisierung der Anzeigeeinheit der AR-Vorrichtung bzw. des Anwenders möglich ist und eine exakte Ausrichtung des Sichtbereichs der Anzeigeeinheit auf die jeweiligen Anlagenkomponenten bestimmbar ist.

Gemäß einem bevorzugten Ausführungsbeispiel sind die zweiten Verbindungen als farbig markierte Linien zwischen den Anlagenkomponenten auf der Anzeigeeinheit anzeigbar. Mit anderen Worten, die unterschiedlichen zweiten Verbindungen der Anlagenkomponenten sind für den Anwender durch die farbig markierten Linien auf der Anzeigeeinheit sichtbar und einfach unterscheidbar, wodurch eine einfachere Orientierung für den Anwender in dem Netzwerk der Industrieanlage möglich ist. Hierbei kann vorzugsweise das Modell zusätzlich als eine miniaturisierte 3D-Karte in einem Teilbereich der Anzeigeeinheit angezeigt werden, wodurch die Orientierung des Anwenders in der Industrieanlage mit der AR-Vorrichtung deutlich verbessert wird.

Gemäß einem weiteren bevorzugten Ausführungsbeispiel ist die Anzeigeeinheit ausgelegt, kabelgebundene und/oder kabellose zweite Verbindungen anzuzeigen, die Datenverbindungen, insbesondere Bussysteme, und/oder Energieversorgungsverbindungen zwischen den Anlagenkomponenten in der realen Industrieanlage repräsentieren. Vorteilhafterweise sind die Datenverbindungen und/oder Energieversorgungsverbindungen unterschiedlich, insbesondere als durchgezogene oder gestrichelte Linien, darstellbar. Hierdurch erhält der Anwender den Vorteil, dass er sämtliche zweite Verbindungen der Anlagenkomponenten bzw. das Netzwerk der Industrieanlage erkennen und auch unterscheiden kann. Dadurch ist es möglich für den Anwender zu erkennen, welche Anlagenkomponenten er beeinflussen würde, wenn er eine bestimmte zweite Verbindung ändert.

Weiterhin ist gemäß einem bevorzugten Ausführungsbeispiel die Anzeigeeinheit ausgelegt, nicht sichtbare Anlagenkomponenten dem Anwender mittels eines Markers und/oder zumindest einer Richtungsanzeige in Richtung der nicht sichtbaren Anlagenkomponenten erkennbar zu machen. Die Richtungsanzeige ist vorteilhafterweise in Form eines Pfeiles auf der Anzeigeeinheit anzeigbar. Vorzugsweise ist die Richtungsanzeige solange in der Anzeigeeinheit sichtbar, bis die Anlagenkomponente für den Anwender sichtbar geworden ist.

Hierdurch besteht der Vorteil, dass der Anwender beispielsweise von der vor dem Anwender befindlichen Steuerung bis zu einer weit entfernt befindlichen Anlagenkomponente entlang der zweiten Verbindung gelotst wird.

Gemäß einem weiteren bevorzugten Ausführungsbeispiel ist ein Auswahlmittel zum selektiven Auswählen einer Anlagenkomponente der Industrieanlage vorgesehen, so dass nur die ausgewählte Anlagenkomponente und deren jeweilige zweiten Verbindungen für den Anwender hervorgehoben angezeigt sind. Insbesondere sind die ausgewählten Anlagenkomponenten, deren jeweiligen zweiten Verbindungen und die mit der ausgewählten Anlagenkomponente verbundenen anderen Anlagenkomponenten blinken und/oder farbig anzeigbar, wobei die nicht ausgewählten Anlagenkomponenten und nicht mit der ausgewählten Anlagenkomponente verbundenen Anlagenkomponenten transparent anzeigbar oder ausgeblendet sind.

Weiterhin umfasst die AR-Vorrichtung gemäß einem bevorzugten Ausführungsbeispiel eine Brille, ein Helmdisplay oder ein elektronisches Kommunikationsgerät, insbesondere ein Smartphone oder ein Touchpad, so dass die Nutzung der AR-Vorrichtung einfach und bequem sein kann.

Die erfindungsgemäße Vorrichtung kann auf ähnliche Weise durch weitere Merkmale ausgestaltet werden und zeigt dabei ähnliche Vorteile. Derartige weitere Merkmale sind beispielhaft, aber nicht abschließend, in den sich an dem unabhängigen Anspruch anschließenden Unteransprüchen beschrieben.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine schematische Darstellung einer Industrieanlage, in der die erfindungsgemäße Augmented-Reality-Vorrichtung verwendet wird;
- Fig. 2: eine schematische Detaildarstellung einer Anzeigeeinheit der erfindungsgemäßen Augmented-Reality-Vorrichtung; und
- Fig. 3: eine weitere schematische Detaildarstellung der Anzeigeeinheit.

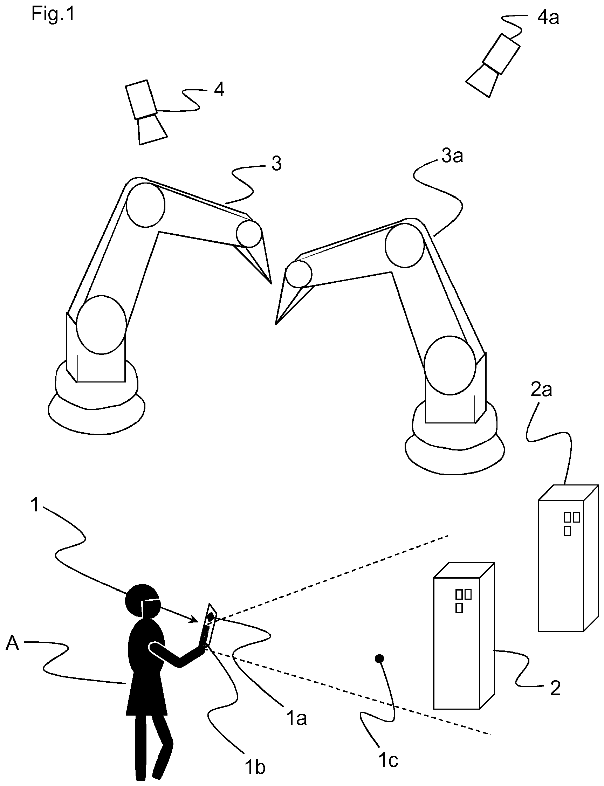

Figur 1 zeigt eine schematische Darstellung einer beispielshaften Industrieanlage, in der ein Anwender A eine erfindungsgemäße Augmented-Reality-Vorrichtung 1, die im Folgenden mit AR-Vorrichtung 1 bezeichnet wird, nutzt.

Die beispielhafte Industrieanlage umfasst zwei Steuerungen 2 und 2a, die jeweils mit einem Aktor 3 und 3a verbunden sind. Es kann auch nur eine Steuerung 2 vorgesehen sein, die mit beiden Aktoren 3 und 3a verbunden ist. Hierbei können die Aktoren 3 und 3a beispielsweise Industrieroboter, Stanz-Maschinen, Transportbänder oder dergleichen sein. Zusätzlich sind die Steuerungen 2 und 2a mit Sensoren 4 und 4a verbunden, die Sensordaten an die Steuerungen 2 und 2a senden, so dass die Steuerungen 2 und 2a Aktorsignale an die Aktoren 3 und 3a aussenden, um die Aktoren 3 und 3a zu steuern. Die Steuerungen 2 und 2a können miteinander und mit einer übergeordneten, nicht dargestellten Gesamtsteuerung verbunden sein. Die Steuerungen 2 und 2a, Aktoren 3 und 3a und Sensoren 4 und 4a werden im Folgenden als Anlagenkomponenten verstanden.

Die AR-Vorrichtung 1 umfasst eine Verarbeitungseinheit 1a, die zum Verarbeiten von Daten vorgesehen ist, wobei die Daten insbesondere CAD-Daten der Industrieanlage umfassen. Unter Verarbeitungseinheit 1a wird ein, auch als CPU bezeichneter, Prozessor verstanden. Vorzugsweise kann der Prozessor auch in einem separat angeordneten Rechner, oder eine in die Steuerung 2 und 2a oder den Sensor 4 und 4a integrierte Recheneinheit vorgesehen sein, so dass eine Übertragung von verarbeiteten Daten an die AR-Vorrichtung 1 möglich ist. Ferner umfasst die AR-Vorrichtung 1 eine Anzeigeeinheit 1b mit einem Sichtbereich 1c, wobei die Anzeigeeinheit 1b vorgesehen ist, die Steuerung 2 und 2a, Steuerungskomponenten und erste Verbindungen zwischen den Steuerungskomponenten als eine erweiterte reale Abbildung anzuzeigen. Die Steuerungskomponenten umfassen beispielsweise Eingangs- und Ausgangseinheiten der Steuerung 2 und 2a, die in der Figur 1 nicht dargestellt sind.

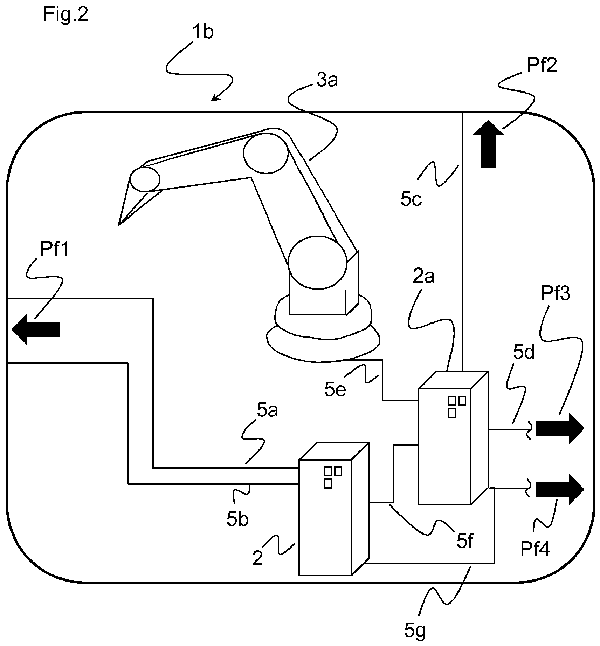

Erfindungsgemäß verarbeitet die Verarbeitungseinheit 1a aus den Daten ein Modell der Industrieanlage mit der Steuerung 2 und 2a, dem Aktor 3 und 3a, dem Sensor 4 und 4a und zweiten (in der Figur 2 dargestellten) Verbindungen als Anlagenkomponenten. Ferner verarbeitet die Verarbeitungseinheit 1a Positionsdaten der Anlagenkomponenten und der Anzeigeeinheit 1b in das Modell. Die Anzeigeeinheit 1b ist erfindungsgemäß ausgelegt, die Industrieanlage mit den Anlagenkomponenten und ihren zweiten Verbindungen in Abhängigkeit von der Position und dem Sichtbereich 1c der Anzeigeeinheit 1b in dem Modell als die erweiterte reale Abbildung darzustellen.

Das heißt mit anderen Worten, wenn der Anwender A beispielsweise die AR-Vorrichtung 1 derart ausrichtet, dass der Sichtbereich 1c der Anzeigeeinheit 1b auf einen speziellen Bereich der Industrieanlage, insbesondere auf die Steuerungen 2 und 2a wie in der Figur 2 dargestellt, gerichtet ist, werden auf der Anzeigeeinheit 1b dem Anwender A die Steuerungen 2 und 2a und ihren zweiten Verbindungen 5a - 5g zu dem jeweiligen mit den Steuerungen 2 und 2a verbundenen sichtbaren Aktor 3a und nicht sichtbaren Aktor 3 bzw. nicht sichtbaren Sensoren 4 und 4a als die erweiterte reale Abbildung angezeigt. Insbesondere sind die zweiten Verbindungen 5a - 5g als farbig markierte Linien in dem Modell bzw. in der erweiterten realen Abbildung auf der Anzeigeeinheit 1b anzeigbar.

In der Industrieanlage sind die kabelgebundenen und/oder kabellosen zweiten Verbindungen 5a -5g meisten verdeckt bzw. für den Anwender A (wie in der Figur 1 dargestellt) nicht sichtbar. Die Anzeigeeinheit 1b der AR-Vorrichtung 1 ist insbesondere ausgelegt, die kabelgebundenen und/oder kabellosen zweiten Verbindungen 5a - 5g anzuzeigen, die Datenverbindungen, insbesondere Bussysteme und/oder Energieversorgungsverbindungen zwischen den Anlagenkomponenten in der realen Industrieanlage repräsentieren. Vorzugsweise sind die Datenverbindungen und/oder Energieversorgungsverbindungen unterschiedlich, insbesondere als durchgezogene, gestrichelte oder ähnlich gestaltete Linien, darstellbar.

In der Figur 2 ist solch eine beschriebene erfindungsgemäße Darstellung des Sichtbereichs 1c der Anzeigeeinheit 1b auf die Industrieanlage gezeigt, in der der Anwender A den Sichtbereich 1c der Anzeigeeinheit 1b auf die beiden Steuerungen 2 und 2a richtet, so dass die in der Figur 1 nicht sichtbaren zweiten Verbindungen 5a - 5g zwischen den Anlagenkomponenten in der Anzeigeeinheit 1b für den Anwender A sichtbar abgebildet sind. Vorzugsweise sind die Positionsdaten der Anzeigeeinheit 1b als GPS-Daten mittels Satelliten oder lokale Positionsdaten mittels lokalen Sensoren 4 und 4a an die Verarbeitungseinheit 1a übermittelbar, so dass eine Ausrichtung des Sichtbereichs 1c der Anzeigeeinheit 1b exakt bestimmbar ist. Zusätzlich kann mittels Marker im Sichtbereich 1c der Anzeigeeinheit 1b die Bestimmung der Ausrichtung des Sichtbereichs 1c durchgeführt werden. Hierbei ist die Verarbeitungseinheit 1a in der Lage, die Marker zu detektieren und anhand von Positionen der Marker in der Industrieanlage die Ausrichtung des Sichtbereichs 1c zu errechnen.

Aus der Anzeigeeinheit 1b kann der Anwender A sämtliche zweite Verbindungen 5a - 5g zwischen den im Sichtbereich 1c befindlichen Steuerungen 2 und 2a und den Aktor 3a und den mit den Steuerungen 2 verbundenen aber nicht sichtbaren Sensoren 4 und 4a sowie dem nicht sichtbaren Aktor 3 erkennen. In diesem Ausführungsbeispiels repräsentieren die zweite Verbindung 5a eine Verbindung zwischen der im Vordergrund befindlichen Steuerung 2 und dem nicht sichtbaren Aktor 3, die zweite Verbindung 5b eine Verbindung zwischen der im Vordergrund befindlichen Steuerung 2 und dem nicht sichtbaren Sensor 4, die zweite Verbindung 5c eine Verbindung zwischen der im Hintergrund befindlichen Steuerung 2a und dem nicht sichtbaren Sensor 4a, die zweite Verbindung 5d eine Verbindung zwischen den beiden Steuerung 2 und 2a und der übergeordneten, nicht sichtbaren Gesamtsteuerung, die zweite Verbindung 5e eine Verbindung zwischen der Steuerung 2a und dem Aktor 3a, die zweite Verbindung 5f eine Verbindung zwischen den beiden Steuerungen 2 und 2a, und die zweite Verbindung 5g eine Verbindung zwischen den beiden Steuerungen 2 und 2a und einer nicht dargestellten Energieversorgung.

Zusätzlich ist die Anzeigeeinheit 1b ausgelegt, die nicht sichtbaren Anlagenkomponenten dem Anwender A mittels eines Markers und/oder zumindest einer Richtungsanzeige in Richtung der nicht sichtbaren Anlagenkomponenten erkennbar zu machen. Das heißt, wie in der Figur 2 dargestellt, ist die Richtungsanzeige in Form von vier Pfeilen Pf1 - Pf4 auf der Anzeigeeinheit 1b angezeigt, so dass wenn der Anwender A den Sichtbereich 1c der Anzeigeeinheit 1b in Richtung eines der Pfeile Pf1 - Pf4 schwenkt, die Anzeigeeinheit 1b die zweite Verbindung 5a - 5g bis zum nicht sichtbaren, mit der jeweiligen Steuerung 2 und 2a verbundenen Anlagenkomponente anzeigt. Hierdurch kann sich der Anwender A einfach entlang der angezeigten zweiten Verbindung 5a - 5g bis zum verbundenen Anlagenkomponenten lotsen lassen. Die Richtungsanzeige bzw. Pfeile Pf1 - Pf4 sind so lange in der Anzeigeeinheit 1b sichtbar, bis die mit der jeweiligen zweiten Verbindung 5a - 5g verbundene Anlagenkomponente für den Anwender A sichtbar geworden ist.

Zusätzlich ist ein Auswahlmittel, insbesondere ein Cursor und Bestätigungsknopf, zum selektiven Auswählen einer Anlagenkomponente der Industrieanlage vorgesehen, so dass nur die ausgewählte Anlagenkomponente und deren jeweiligen zweiten Verbindungen 5a - 5g für den Anwender A hervorgehoben angezeigt sind.

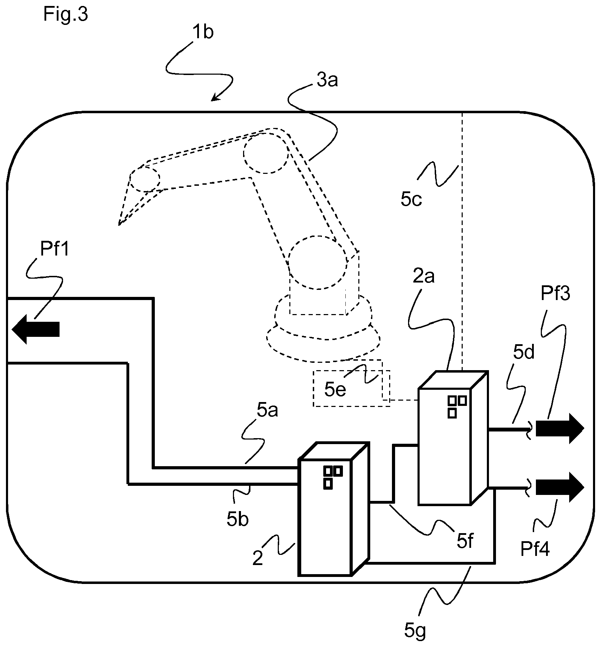

Wie in der Figur 3 dargestellt, ist die im Vordergrund befindliche Steuerung 2 vom Anwender mittels dem Auswahlmittel ausgewählt, so dass die ausgewählte Steuerung 2, deren jeweiligen zweiten Verbindungen 5a, 5b, 5d, 5f und 5g und die mit der ausgewählten Steuerung 2 verbundenen Anlagenkomponenten fettgedruckt, vorzugsweise blinken und/oder farbig, angezeigt sind. Die nicht mit der ausgewählten Steuerung 2 verbundenen Anlagenkomponenten, nämlich der Aktor 3a und die zweite Verbindungen 5c und 5e, sind transparent bzw. mit gestrichelten Linien angezeigt oder können auch ausgeblendet sein.

Hierdurch ist eine Orientierung des Anwenders A im Netzwerk der zweiten Verbindungen 5a - 5g der Industrieanlage erleichtert.

Die AR-Vorrichtung 1 umfasst vorzugsweise eine Brille, ein Helmdisplay oder ein elektronisches Kommunikationsgerät, wobei das Kommunikationsgerät ein Smartphone oder ein Touchpad sein kann. Die AR-Vorrichtung 1 ist somit sehr handlich und einfach einzusetzen, so dass der Anwender A mit der AR-Vorrichtung 1 eine hohe Bewegungsfreiheit hat.

### Bezugszeichenliste

- 1: Augmented-Reality-Vorrichtung / AR-Vorrichtung
- 1a: Verarbeitungseinheit
- 1b: Anzeigeeinheit
- 1c: Sichtbereich
- 2, 2a: Steuerung
- 3, 3a: Aktor
- 4, 4a: Sensor
- 5a - 5g: Zweite Verbindung

- A: Anwender
- Pf1 - Pf4: Richtungsanzeige bzw. Pfeil

## Patentansprüche

1. Augmented-Reality-Vorrichtung (1) umfassend
eine Verarbeitungseinheit (1a), die zum Verarbeiten von Daten vorgesehen ist, und
eine Anzeigeeinheit (1b) mit einem Sichtbereich (1c), die vorgesehen ist, eine Steuerung (2, 2a), Steuerungskomponenten und erste Verbindungen zwischen den Steuerungskomponenten als eine erweiterte reale Abbildung anzuzeigen, wobei die Steuerung (2, 2a) Sensordaten von zumindest einem Sensor (4, 4a) empfängt und Aktorsignale an zumindest einen Aktor (3, 3a) einer Industrieanlage sendet,
**dadurch gekennzeichnet, dass**
die Verarbeitungseinheit (1a) aus den Daten ein Modell der Industrieanlage mit der Steuerung (2, 2a), dem Sensor (4, 4a), dem Aktor (3, 3a) und zweiten Verbindungen (5a - 5g) als Anlagenkomponenten verarbeitet, und Positionsdaten der Anlagenkomponenten und der Anzeigeeinheit (1b) in das Modell verarbeitet,
wobei die Anzeigeeinheit (1b) ausgelegt ist, die Industrieanlage mit den Anlagenkomponenten und ihren zweiten Verbindungen (5a - 5g) in Abhängigkeit von der Position und dem Sichtbereich (1c) der Anzeigeeinheit in dem Modell als die erweiterte reale Abbildung darzustellen.

2. Augmented-Reality-Vorrichtung (1) nach Anspruch 1, wobei die Daten CAD-Daten der Industrieanlage umfassen.

3. Augmented-Reality-Vorrichtung (1) nach Anspruch 1 oder 2, wobei die Positionsdaten der Anzeigeeinheit (1b) als GPS-Daten mittels Satelliten oder lokale Positionsdaten mittels lokalen Sensoren (4, 4a) an die Verarbeitungseinheit (1a) übermittelbar sind.

4. Augmented-Reality-Vorrichtung (1) nach einem der vorhergehenden Ansprüche, wobei die zweiten Verbindungen (5a - 5g) als farbig markierte Linien in dem Modell auf der Anzeigeeinheit (1b) anzeigbar sind.

5. Augmented-Reality-Vorrichtung (1) nach einem der vorhergehenden Ansprüche, wobei die Anzeigeeinheit (1b) ausgelegt ist, kabelgebundene und/oder kabellose zweite Verbindungen (5a - 5g) anzuzeigen, die Datenverbindungen, insbesondere Bussysteme, und/oder Energieversorgungsverbindungen zwischen den Anlagenkomponenten repräsentieren.

6. Augmented-Reality-Vorrichtung (1) nach Anspruch 5, wobei die Datenverbindungen und/oder Energieversorgungsverbindungen unterschiedlich, insbesondere als durchgezogene, gestrichelte oder ähnlich gestaltete Linien, darstellbar sind.

7. Augmented-Reality-Vorrichtung (1) nach einem der vorhergehenden Ansprüche, wobei die Anzeigeeinheit (1b) ausgelegt ist, nicht sichtbare Anlagenkomponenten dem Anwender mittels eines Markers und/oder zumindest einer Richtungsanzeige (Pf1 - Pf4) in Richtung der nicht sichtbaren Anlagenkomponenten erkennbar zu machen.

8. Augmented-Reality-Vorrichtung (1) nach Anspruch 7, wobei die Richtungsanzeige (Pf1 - Pf4) in Form eines Pfeiles auf der Anzeigeeinheit (1b) anzeigbar ist.

9. Augmented-Reality-Vorrichtung (1) nach Anspruch 7 oder 8, wobei die Richtungsanzeige (Pf1 - Pf4) so lange in der Anzeigeeinheit (1b) sichtbar ist, bis die Anlagenkomponente für den Anwender (A) sichtbar geworden ist.

10. Augmented-Reality-Vorrichtung (1) nach einem der vorhergehenden Ansprüche, wobei ein Auswahlmittel zum selektiven Auswählen einer Anlagenkomponente der Industrieanlage vorgesehen ist, so dass nur die ausgewählte Anlagenkomponente und deren jeweiligen zweiten Verbindungen (5a - 5g) für den Anwender (A) hervorgehoben angezeigt sind.

11. Augmented-Reality-Vorrichtung (1) nach Anspruch 10, wobei die ausgewählte Anlagenkomponente, deren jeweiligen zweiten Verbindungen (5a - 5g) und die mit der ausgewählten Anlagenkomponente verbundenen anderen Anlagenkomponenten blinken und/oder farbig anzeigbar sind und die nicht ausgewählten Anlagenkomponenten und nicht mit der ausgewählten Anlagenkomponente verbundenen Anlagenkomponenten transparent anzeigbar oder ausgeblendet sind.
